Europäisches Patentamt

(19) European Patent Office

Office européen des brevets

(11) Numéro de publication: **0 177 377
B1**

(12) **FASCICULE DE BREVET EUROPEEN**

(45) Date de publication du fascicule du brevet:
**07.12.88**

(51) Int. Cl.⁴: **H 01 L 31/02,** H 01 L 27/14

(21) Numéro de dépôt: **85401605.2**

(22) Date de dépôt: **06.08.85**

(54) **Procédé de réalisation des lignes de connexion d'un dispositif à semiconducteurs.**

(30) Priorité: **10.08.84 FR 8412677**

(43) Date de publication de la demande:
**09.04.86 Bulletin 86/15**

(45) Mention de la délivrance du brevet:
**07.12.88 Bulletin 88/49**

(84) Etats contractants désignés:
**DE GB NL**

(56) Documents cités:
**DE-B- 1 283 975
US-A- 3 671 313
US-A- 4 025 793
US-A- 4 236 165**

(73) Titulaire: **THOMSON-CSF, 173, Boulevard Haussmann,
F-75379 Paris Cédex 08 (FR)**

(72) Inventeur: **Montanari, Jean-Louis, THOMSON-CSF
SCPI 173, bld Haussmann, F-75379 Paris Cedex 08 (FR)**

(74) Mandataire: **Ruellan-Lemonnier, Brigitte et al,
THOMSON-CSF SCPI 19, avenue de Messine,
F-75008 Paris (FR)**

## Description

La présente invention concerne un procédé de fabrication d'un dispositif à semiconducteurs, plus particulièrement un perfectionnement au mode de réalisation des lignes de connexion du dispositif à semiconducteurs lorsque celui-ci est réalisé, notamment, en utilisant les technologies couches minces ou des technologies similaires.

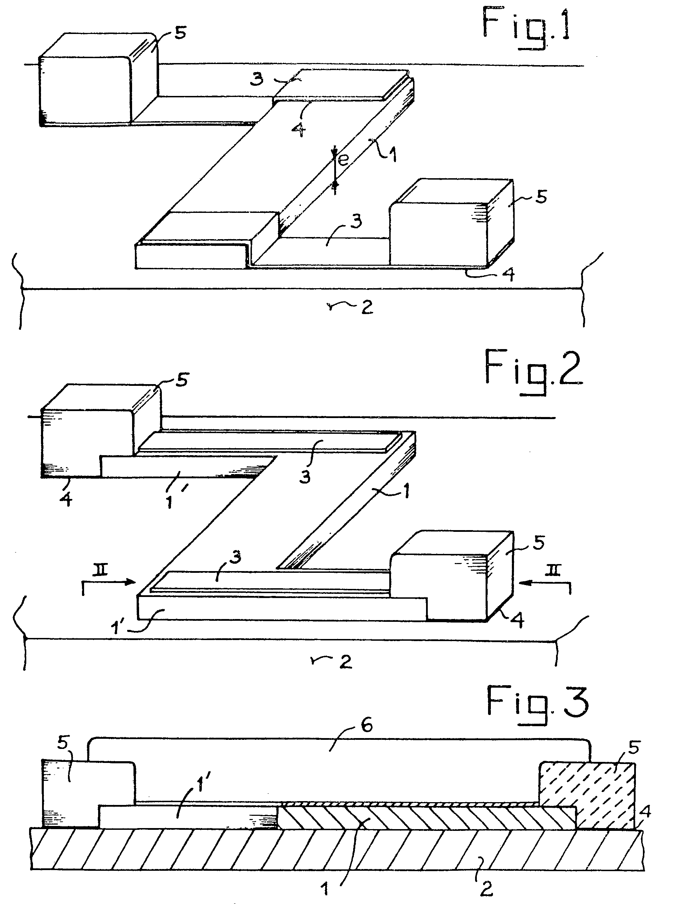

Les procédés actuellement utilisés consistent principalement à déposer sur un substrat isolant, de préférence en verre, en céramique ou similaire, une couche de matériau actif, à délimiter simultanément ou postérieurement au dépôt un ou des éléments actifs, à déposer à partir des éléments actifs des lignes de connexion et enfin à réaliser les plots de contact. Différentes techniques peuvent être utilisées pour le dépôt de la couche de matériau actif, telles que l'évaporation sous vide, le dépôt chimique ou similaire. Toutefois, quelle que soit la technique de dépôt utilisée, la délimitation des éléments actifs est réalisée en utilisant des masques. On observe donc entre les éléments actifs et le substrat une différence de niveau comme représenté sur la figure 1 qui concerne un élément photoconducteur 1 en séléniure de plomb réalisé sur un substrat 2 en quartz dépoli. Dans ce cas, la différence de niveau présente une épaisseur e d'environ 2 μm. Il en résulte que les lignes de connexion 3 sont réalisées sur des surfaces se trouvant à deux niveaux différents, ce qui entraine le passage de marches d'épaisseur non négligeable. Ces lignes de connexion étant, de préférence, réalisées par évaporation sous vide d'un métal conducteur, on observe très souvent au niveau de la marche des problèmes de coupure ou d'uniformisation du dépôt entrainant la création d'une résistance série.

De plus, les lignes de connexion 3 sont réalisées de préférence en or. Cependant l'or adhère difficilement sur le substrat isolant. Il est donc nécessaire de prévoir une couche d'accrochage 4 entre le substrat et la couche d'or. Cette couche d'accrochage est, de préférence, réalisée en chrome. Or cette couche d'accrochage est aussi déposée sur le matériau actif et il en résulte qu'elle est génératrice de bruit.

La présente invention a donc pour but de proposer un perfectionnement au procédé connu de fabrication d'un dispositif à semiconducteurs qui permet de résoudre les problèmes ci-dessus.

En conséquence, la présente invention a pour objet un procédé de fabrication d'un dispositif à semiconducteurs comportant sur un substrat, au moins des éléments actifs, des lignes de connexion et des plots de contact caractérisé en ce que:

– on dépose sur le substrat, de manière connue, au moins une couche d'un matériau actif,

– on délimite dans la couche de matériau actif, simultanément ou postérieurement au dépôt, des zones actives correspondant aux éléments actifs et passives correspondant aux lignes de connexion, puis

– on réalise, de manière connue, les lignes de connexion sur les zones passives et les plots de contact.

Dans ce cas, les lignes de connexion sont réalisées sur des zones présentant la même épaisseur que les éléments actifs. Il n'y a donc plus de problème de marches. D'autre part, les lignes de connexion sont réalisées, de préférence, en un métal conducteur présentant une bonne adhérence avec le matériau actif. En conséquence, il n'est plus nécessaire de prévoir une couche d'accrochage entre le matériau actif et la couche métallique réalisant les lignes de connexion.

D'autres caractéristiques et avantages de la présente invention apparaîtront à la lecture de la description de divers modes de réalisation faite avec référence aux dessins ci-annexés dans lesquels:

– la figure 1, déjà décrite, est une vue en perspective schématique agrandie d'un élément photoconducteur réalisé selon le procédé de l'art antérieur,

– la figure 2 est une vue en perspective schématique agrandie d'un élément photoconducteur réalisé selon le procédé de la présente invention, et

– la figure 3 est une vue en coupe par II–II de figure 2.

Dans les figures, les mêmes éléments portent les mêmes références. D'autre part pour des raisons de clarté, les côtes et proportions des divers éléments n'ont pas été respectée.

Le procédé de fabrication conforme à la présente invention est décrit en se référant à la réalisation d'un élément photoconducteur comme représenté sur les figures 2 et 3. Toutefois, il est évident pour l'homme de l'art que ce procédé peut être utilisé lors de la fabrication de tout dispositif à semiconducteurs dont les éléments actifs doivent être connectés à des plots de contact ou à d'autres éléments et présentent une surépaisseur par rapport au substrat.

Pour réaliser un élément photoconducteur en séléniure de plomb par exemple, conformément au procédé de la présente invention, on dépose tout d'abord sur l'ensemble du substrat 2 en quartz dépoli, une couche de séléniure de plomb présentant une épaisseur d'environ 2 μm. Ce dépôt est réalisé de manière classique par réaction de la sélénourée sur l'acétate de plomb.

Ensuite, on délimite chimiquement en utilisant un masque, des zones actives 1 correspondant à l'élément photoconducteur et passives 1' correspondant aux lignes de connexion. De manière plus spécifique, les zones actives et passives sont délimitées par photogravure en utilisant des masques au chrome et une gravure par le brome du séléniure de plomb.

On dépose, alors, par évaporation sous vide par exemple, une couche uniforme d'un métal conducteur tel que de l'or présentant une épaisseur d'environ 200 nm (2000 Å). Puis on délimite par photogravure les lignes de connexion 3.

On réalise enfin les plots de contact 5. Pour cela on effectue à travers un masque délimitant la surface de base des plots, le dépôt par évaporation sous vide d'une couche d'accrochage 4 lorsque le plot de contact est réalisé en partie sur le substrat comme représenté sur les figures 2 et 3. Cette couche d'accrochage peut être réalisée en chrome, en titane ou en molybdène. Ce mode de réalisation préférentiel du plot de contact permet d'obtenir des plots de contact plus rigides. Toutefois, il est aussi possible de réaliser les plots de contact uniquement sur l'extrémité des zones passives 1' sans dépôt de couche d'accrochage.

Sur la couche d'accrochage, on dépose ensuite sur une épaisseur de 10 μm environ une couche d'un métal conducteur tel que l'aluminium, réalisant le plot de contact 5 proprement dit.

Ensuite, l'ensemble du dispositif à l'exclusion des plots de contact peut être recouvert par évaporation sous vide par exemple, d'une couche de passivation 6 en séléniure d'arsenic dans le présent cas.

Avec le procédé de la présente invention, les lignes de connexion sont déposées sur une zone d'épaisseur uniforme. D'autre part, les lignes de connexion sont généralement réalisées en un métal présentant une bonne adhérence avec le matériau actif. De ce fait, il n'est pas nécessaire de prévoir une couche d'adhérence entre la zone passive et les lignes de connexion ce qui diminue le bruit.

Il est évident pour l'homme de l'art que les méthodes de dépôt, les matériaux et les épaisseurs des différentes couches ainsi que la nature du substrat ont été donnés uniquement à titre d'exemple et ces différents paramètres peuvent être modifiés sans sortir du cadre de la présente invention.

D'autre part, le mode de réalisation décrit ne comporte qu'une seule couche active, il est évident pour l'homme de métier que la présente invention peut aussi s'appliquer à des dispositifs comportant plusieurs couches actives en des matériaux différents.

## Revendications

1. Procédé de fabrication d'un dispositif à semiconducteurs comportant sur un substrat (2), au moins des éléments actifs (1), des lignes de connexion (3) et des plots de contact (5) caractérisé en ce que:
   - on dépose sur le substrat (2), de manière connue, au moins une couche d'un matériau actif,
   - on délimite dans la couche de matériau actif, simultanément ou postérieurement au dépôt, des zones actives (1) correspondant aux éléments actifs et passives (1') correspondant aux lignes de connexion, puis
   - on réalise, de manière connue, les lignes de connexion (3) sur les zones passives (1') et les plots de contact.

2. Procédé selon la revendication 1 caractérisé en ce que les plots de contact sont réalisés sur l'extrémité des lignes de connexion.

3. Procédé selon la revendication 1 caractérisé en ce que les plots de contact sont réalisés à la fois sur l'extrémité des lignes de connexion et sur le substrat.

4. Procédé selon la revendication 3 caractérisé en ce que, avant de réaliser les plots de contact, on dépose sur la surface correspondant aux plots, une couche d'accrochage (4).

5. Procédé selon la revendication 1 caractérisé en ce que les zones actives et passives (1, 1') sont délimitées par masquage.

6. Procédé selon la revendication 1 caractérisé en ce que les opérations de dépôt et de délimitation des zones actives et passives sont recommencées plusieurs fois avec des matériaux actifs différents.

## Patentansprüche

1. Verfahren zur Herstellung einer Halbleitervorrichtung mit einem Substrat (2), auf dem mindestens aktive Elemente (1), Verbindungsleitungen (3) und Kontaktflächen (5) vorhanden sind, dadurch gekennzeichnet, dass:
   - auf dem Substrat (2) in bekannter Weise mindestens eine Schicht eines aktiven Stoffes aufgebracht wird,
   - in der Schicht des aktiven Stoffes, gleichzeitig mit der Aufbringung oder danach, aktive Zonen (1) abgegrenzt werden, die aktiven Elemente und passiven Elementen (1') entsprechen, welche den Verbindungsleitungen entsprechen, und dann
   - in bekannter Weise Verbindungsleitungen (3) auf den passiven Zonen (1') und den Kontaktflächen hergestellt werden.

2. Verfahren nach Anspruch 1, dadurch gekennzeichnet, dass die Kontaktflächen auf den Enden der Verbindungsleitungen hergestellt werden.

3. Verfahren nach Anspruch 1, dadurch gekennzeichnet, dass die Kontaktflächen zugleich auf den Enden der Verbindungsleitungen und auf dem Substrat hergestellt werden.

4. Verfahren nach Anspruch 3, dadurch gekennzeichnet, dass vor Herstellung der Kontaktflächen eine Haftschicht (4) auf der den Klötzen entsprechenden Oberfläche angebracht wird.

5. Verfahren nach Anspruch 1, dadurch gekennzeichnet, dass die aktiven und passiven Zonen (1, 1') durch Maskierung abgegrenzt werden.

6. Verfahren nach Anspruch 1, dadurch gekennzeichnet, dass die Arbeitsgänge der Beschichtung und der Abgrenzung der aktiven und passiven Zonen mehrere Male mit verschiedenen aktiven Stoffen wiederholt werden.

## Claims

1. A process for manufacturing a semiconductor device comprising, on a substrate (2) at least active elements (1), connection lines (3) and contact blocks (5), characterized in that:
   - at least one layer of an active material is deposited on the substrate (2) in a known manner,
   - active zones (1), which correspond to the active and passive (1') elements corresponding to the connection lines, are delimited, simultaneously with their deposition or afterwards, in the layer of active material, and then
   - connection lines (3) are realized on the passive zones (1') and the contact blocks in a known manner.

2. A process according to claim 1, characterized in that the contact blocks are realized on the ends of the connection lines.

3. A process according to claim 1, characterized in that the contact blocks are realized as well on the ends of the connection lines as on the substrate.

4. A process according to claim 3, characterized in that an adherence layer (4) is deposited on the surface corresponding to the blocks before the contact blocks are realized.

5. A process according to claim 1, characterized in that the active and passive zones (1, 1') are delimited by masking.

6. A process according to claim 1, characterized in that the operations of depositing and of delimiting of the active and passive zones are repeated several times with different active materials.

Fig.1

Fig.2

Fig.3